# EUROPÄISCHE PATENTSCHRIFT

(11) **EP 0 735 630 B1**
(45) Veröffentlichungstag und Bekanntmachung des Hinweises auf die Patenterteilung: **07.07.1999**
(21) Anmeldenummer: 96103252.1
(22) Anmeldetag: 02.03.1996
(51) Int. Cl.: H01R 33/08, G01R 31/44

(54) **Lampenfassung, insbesondere für Leuchtstofflampen**
Lamp holder especially for fluorescent lamps
Douille de lampe en particulier pour lampes fluorescentes

(30) Priorität: 31.03.1995 DE 19511887
(43) Veröffentlichungstag der Anmeldung: 02.10.1996
(73) Patentinhaber: Brökelmann, Jaeger & Busse GmbH & Co, D-59755 Arnsberg (DE)
(72) Erfinder: Henrici, Dieter, Dipl.-Ing., 59757 Arnsberg (DE); Vogt, Karl-Wilhelm, 59469 Ense (DE)
(74) Vertreter: Patentanwälte Ostriga & Sonnet

(56) Entgegenhaltungen:
- FR-A- 2 301 934
- US-A- 4 617 519

## Beschreibung

Die Erfindung bezieht sich auf eine Lampenfassung insbesondere für Leuchtstofflampen mit einem aus Isolierstoff bestehenden Fassungskörper und darin eingeschlossenen Kontaktstücken für die Lampenkontaktstifte sowie Anschlußklemmen für Leiter, mit Öffnungen in einer Fassungskörperwand zum Einführen von stiftförmigen Prüfspitzen eines Prüfadapters in den Fassungskörper hinein, wo sie auf die Kontaktstücke auftreffen, und mit jeweils einem die Öffnungen umgebenden kanalbildenden Isolierschutzkragen zur Einhaltung der erforderlichen Kriech- und Luftstrecken.

Für eine manuelle oder automatische Leuchtenendprüfung wird ein Verfahren angewandt, welches es gestattet, die fertige, also mit den elektrischen Bauelementen und der Verdrahtung versehene Leuchte auf ihre Funktionsfähigkeit hin zu prüfen, ohne daß diese Prüfung die Montage der Lampen in die zu prüfende Leuchte erfordert. Zu diesem Zweck wird an die elektrischen Anschlußklemmen und/oder die Lampenfassungen ein Prüfkopf (Adapter) angesetzt, der Prüfspitzen (auch "Testelektroden" genannt), enthält, die mit den Kontaktstücken in der Lampenfassung in Verbindung gebracht werden. Der Prüfkopf ist über elektrische Leitungen an eine Auswerteeinrichtung angeschlossen.

Um einen solchen Test möglichst sicher und einfach ausführen sowie auch automatisieren zu können, wird die Lampenfassung von der äußeren oberen Stirnseite her kontaktiert. Um dies zu ermöglichen, sind solche Fassungen in besonderer Weise ausgestaltet und weisen auf der Fassungsoberseite, an die der Prüfkopf angesetzt wird, zwei Öffnungen auf, durch die die Prüfspitzen von außen an die Kontaktstücke im Fassungsinnern gebracht werden können. Zur Einhaltung der notwendigen Kriechund Luftstrecken sind diese Öffnungen jeweils von einem kanalbildenden Isolierschutzkragen umgeben. Allein hierdurch unterscheidet sich die bisher für das Prüfverfahren ("Top Test" genannt) geeignete Lampenfassung von ansonsten identisch bauenden Lampenfassungen.

Da der Top Test nicht grundsätzlich angewandt wird, gibt es neben jeder Top Test-geeigneten Fassung eine zweite Ausführung, die die kanalbildenden Isolierschutzkragen und entsprechend die Öffnungen in der Fassungskörperwand nicht aufweist. Ein Grund für diesen herstellungstechnischen und logistischen Mehraufwand besteht darin, daß die mit den Isolierschutzkragen versehenen Lampenfassungen nicht in jeder Leuchte Platz finden, weil eventuell der Einbauraum zu gering ist. Hierfür steht dann die Alternativfassung zur Verfügung.

Der Erfindung liegt die Aufgabe zugrunde, eine Lampenfassung der im Oberbegriff des Anspruches 1 näher umrissenen Art anzugeben, die in geschickter Weise so gestaltet ist, daß sie einerseits eine Bauartenvereinheitlichung erlaubt und andererseits eine besonders sichere und verschleißarme Kontaktierung durch die Prüfspitzen des Prüfadapters gewährleistet.

Die Erfindung löst diese Aufgabe in erster Linie und im wesentlichen dadurch, daß an jedem Kontaktstück ein besonderer Kontaktabschnitt als Prüfstiftauflager ausgebildet ist, der vor der inneren Mündung des Isolierstoffkanals im wesentlichen lotrecht zu ihm ausgerichtet ist, und daß der Isolierschutzkragen von der Außenseite des Fassungskörpers nach innen in den Fassungskörper eingezogen ist.

Die Lampenfassung entsprechend der Erfindung zeichnet sich einerseits dadurch aus, daß im Unterschied zum Stand der Technik, bei dem die Prüfspitzen auf Kontaktabschnitte auftrafen, die unter einem spitzen Winkel zur Achse der Prüfspitzen schräg verliefen, und deshalb an den Kontakten abgleiten, abbiegen oder auch den Kontakt verformen konnten, nunmehr ein echtes Prüfstiftauflager geschaffen ist, das zu den Prüfstiften definiert angeordnet ist. Dadurch können die Prüfspitzen nicht mehr auf Biegung beansprucht werden, sondern nur auf Druck, wobei jedoch die üblicherweise auftretenden Druckkräfte bezüglich des Knickverhaltens der Prüfstifte völlig unkritisch sind.

Gegenüber dem Stand der Technik besteht der weitere erhebliche Vorteil, daß die Fassung keine nach außen vorragenden Isolierschutzkragen mehr aufweist, die nunmehr gewissermaßen "nach innen eingestülpt" angeordnet sind. Daraus ergibt sich, daß auch die für einen Top Test geeignete Lampenfassung entsprechend der Erfindung überall dort eingesetzt werden kann, wo der Einbauraum beschränkt ist. Hieraus resultiert, daß nur noch ein einheitlicher Fassungskörper erforderlich ist. Es muß nicht mehr von vornherein ein Fassungskörper für einen Top Test ausgewählt werden oder einer der anderen Bauform. Dadurch wird der Fertigungsaufwand ebenso verringert wie die Lagerhaltung und Logistik.

Beide beanspruchten Merkmale wirken auch im Sinne einer Kombination. Denn es wäre bei der bekannten Lampenfassung mit nach außen weisenden Isolierschutzkragen praktisch unmöglich gewesen, unter der unteren Kanalmündung ein echtes Prüfspitzenauflager am Kontaktstück ausbildet, denn in dem möglichen Bereich befand sich ein aus Platzmangel praktisch nicht mehr in der gewünschten Richtung formlich zu beeinflussender Kontaktendabschnitt. Im wesentlichen hat erst der weitere Gedanke, die Auftreffstelle der Prüfspitzen weiter ins Fassungsinnere hinein zu verlegen, die Grundlage für das Prüfspitzenauflager geschaffen. Und hierdurch wiederum erst konnte der Isolierschutzkragen nach innen gezogen werden, woraus sich die zusätzlichen weiteren Vorteile ergeben haben.

Nach einer Weiterbildung des Erfindungsgegenstandes kann der als Prüfstiftauflager dienende Kontaktabschnitt aus einer stufenartigen Verkröpfung des streifenförmigen Kontaktabschnittes gebildet sein. Ein damit einhergehender besonderer Vorteil besteht in der mit der Verkröpfung geschaffenen zusätzlichen Versteifung des Kontaktabschnitts im Prüfspitzen-Belastungsbereich.

Eine alternative Gestaltung, die vorteilhaft erscheint, weil sie besonders einfach herzustellen ist, besteht darin, daß der als Prüfstiftauflager dienende Kontaktabschnitt als aus einem streifenförmigen Kontaktabschnitt ausgeschnittene und unter den Isolierschutzkragen umgebogene Zunge ausgebildet ist. In diesem Zusammenhang ist es ferner vorteilhaft, wenn das Kontaktstück ein sich über den Bereich des Prüfstiftauflagers hinaus erstreckendes freies Ende aufweist und daß dieses freie Ende des Kontaktstücks im Fassungskörper festgelegt ist. Hieraus resultiert in besonderem Maße ein sehr stabiles und vor allem statisch definiertes Prüfstiftauflager, da das festgelegte freie Ende des Kontaktstückes eine unzulässige Verlagerung des Prüfstiftauflagers wirksam verhindert.

Im übrigen versteht man die Erfindung am besten aus ihrer nachfolgenden Beschreibung anhand eines in den Zeichnungen dargestellten Ausführungsbeispiels. Es zeigen:
- Fig. 1: eine Lampenfassung in Ansicht,
- Fig. 2: eine teilweise geschnittene Stirnansicht der Fassung nach Fig. 1,
- Fig. 3: die im Fassungskörper der Lampenfassung eingesetzten Kontaktstücke als einstückig kombinierte Leiteranschlußklemmen/Lampenkontakte, und
- Fig. 4: eine Seitenansicht eines der untereinander identischen Kontaktstücke.

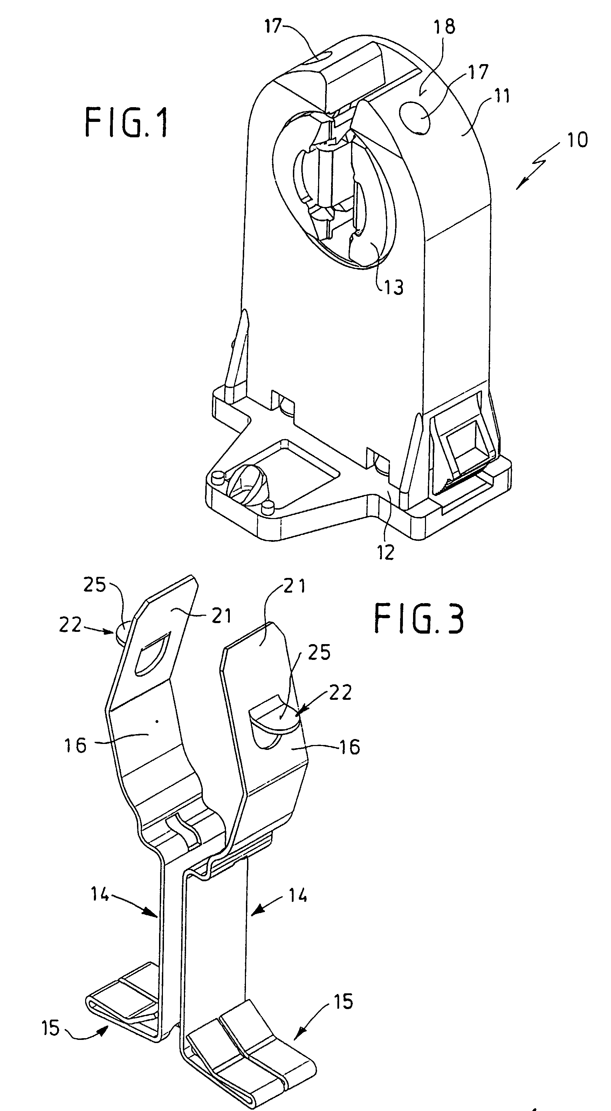

Fig. 1 zeigt in perspektivischer Ansicht eine Lampenfassung für endseitig gesockelte, röhrenförmige Leuchtstofflampen mit zwei Kontaktstiften an jedem Sockel. Die insgesamt mit 10 bezeichnete Lampenfassung weist einen Fassungskörper 11, ein Fußstück 12 und einen sogenannten Rotor 13 auf, die sämtlich aus isolierendem Kunststoffmaterial bestehen.

Der Fassungskörper 11 nimmt im Innern zwei identisch geformte Kontaktstücke 14 auf, die jeweils eine schraubenlose Anschlußklemme 15 für von der Unterseite des Fußstücks 12 her in den Fssungskörper 11 eingeführte elektrische Leiter aufweisen und, in einstückiger Bauform, zwei konkav zueinander gekrümmte Kontaktabschnitte 16 ausbilden, die im Innern des Fassungskörpers 11 den Rotor 13 auf einander gegenüberliegenden Seiten umgreifen und zur Kontaktierung mit den Kontaktstiften einer Leuchtstofflampe dienen.

Die in Fig. 1 dargestellte Fassung unterscheidet sich von einer 'normalen' Leuchtstofflampenfassung lediglich durch die beiden in Fig. 1 ersichtlichen Wandöffnungen 17. Von einer Lampenfassung nach dem eingangs geschilderten Stand der Technik mit Möglichkeit zur Leuchtenfunktionsprüfung unterscheidet sich der in Fig. 1 gezeigte Fassungskörper 11 noch dadurch, daß auch im Bereich der Öffnung 17 die Außenfläche 18 des Fassungskörpers 11 vollkommen vorsprungsfrei gestaltet ist.

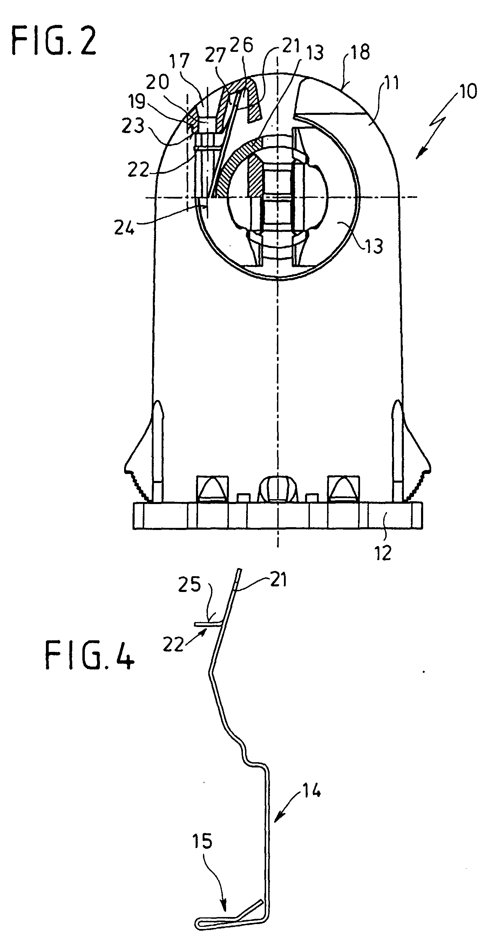

Erfindungsgemäße Besonderheiten sind einerseits am Fassungskörper 11 und andererseits am Kontaktstück 14 ausgebildet. Beide Merkmale in ihrer Ausgestaltung und Zuordnung zueinander zeigt Fig. 2:

Jeder außen am Fassungskörper 11 sichtbaren Öffnung 17 schließt sich ein Isolierschutzkragen 19 an, der von der Außenseite 18 des Fassungskörpers nach innen in den Fassungskörper 11 hineingezogen ist. Es entsteht somit ein Kanal 20, in den eine nicht dargestellte Prüfspitze eines Prüfadapters von oben her eingeführt werden kann.

Zur Kontaktierung der Prüfspitze mit dem Kontaktstück 14 ist an diesem, und zwar nahe seinem oberen Endabschnitt 21 eine Zunge 22 ausgeschnitten und so nach auswärts umgebogen, daß sie mit geringem Abstand unterhalb der Mündung 23 des Isolierschutzkragens 19 zu liegen kommt, und zwar möglichst lotrecht zur Längsachse 24 des Kanals 20. Diese Zunge 22 bildet (siehe auch Fig. 2 und 4) mit ihrer nach außen bzw. oben weisenden Seite ein stabiles Prüfstiftauflager 25 aus.

Das freie Ende 21 des Kontaktstücks 14 ist, wie ebenfalls Fig. 2 veranschaulicht, in einer Tasche 26 aufgenommen und an einem Anschlag 27 angelehnt fixiert. Dieser Anschlag 27 liegt auf derselben Seite, zu der hin die Prüfstiftauflager-Zunge 22 ausgebogen ist. Somit ist erkennbar, daß eine auf die Oberseite 25 der Zunge 22 auftreffende Prüfspitze den Kontaktabschnitt, an dem die Zunge 22 ausgebildet ist, selbst praktisch kaum verformen kann, insbesondere nicht auf Biegung. Das Prüfstiftauflager ist folglich lagegerecht stabilisiert.

## Patentansprüche

1. Lampenfassung für Stiftsockellampen, insbesondere für Leuchtstofflampen, mit einem aus Isolierstoff bestehenden Fassungskörper (11) und darin eingeschlossenen Kontaktstücken (14) für die Lampenkontaktstifte sowie Anschlußklemmen (15) für Leiter, mit Öffnungen (17) in einer Fassungskörperwand zum Einführen von stiftförmigen Prüfspitzen eines Prüfadapters in den Fassungskörper hinein, wo sie auf die Kontaktstücke auftreffen, und mit jeweils einem die Öffnungen (17) umgebenden kanalbildenden Isolierschutzkragen (19) zur Einhaltung der erforderlichen Kriech- und Luftstrecken, dadurch gekennzeichnet, daß an jedem Kontaktstück (14) ein besonderer Kontaktabschnitt als Prüfstiftauflager (25) ausgebildet ist, der vor dem inneren Ende (23) des Isolierschutzkragens (19) im wesentlichen lotrecht zu ihm ausgerichtet ist, und daß der Isolierschutzkragen (19) von der Außenseite (18) des Fassungskörpers (11) nach innen in den Fassungskörper (11) eingezogen ist.

2. Lampenfassung nach Anspruch 1, dadurch gekennzeichnet, daß der als Prüfstiftauflager (25) dienende Kontaktabschnitt aus einer etwa stufenartigen Verkröpfung des streifenförmigen Kontaktabschnitts gebildet ist.

3. Lampenfassung nach Anspruch 1, dadurch gekennzeichnet, daß der als Prüfstiftauflager (25) dienende Kontaktabschnitt als aus einem streifenförmigen Kontaktabschnitt ausgeschnittene und unter den Isolierschutzkragen (19) umgebogene Zunge (22) ausgebildet ist.

4. Lampenfassung nach Anspruch 1, dadurch gekennzeichnet, daß das Kontaktstück (14) ein sich über den Bereich des Prüfstiftauflagers (25) hinaus erstreckendes freies Ende (21) aufweist, welches im Fassungskörper (11) an einem Anschlag (27) festgelegt ist.

## Claims

1. Lamp socket for pin-base lamps, in particular for fluorescent lamps, the said lamp socket having a socket body (11) consisting of insulating material and contact pieces (14) enclosed therein for the contact pins of the lamp, and also connecting terminals (15) for conductors, having apertures (17) in one wall of the socket body for the introduction of the pin-shaped test prods of a test adapter into the socket body, where they impinge upon the contact pieces, and having an insulating protective collar (19) in each case, which surrounds the apertures (17) and forms a duct, for complying with the necessary creepage paths and air gaps, characterised in that there is constructed as a test pin support (25) on each contact piece (14), a special contact section which is oriented, in front of the inner end (23) of the insulating protective collar (19), essentially perpendicularly thereto, and that the said insulating protective collar (19) is drawn inwards into the body (11) of the socket from the outside (18) of the latter.

2. Lamp socket according to claim 1, characterised in that the contact section serving as the test pin support (25) is formed from an approximately step-like cranked portion on the strip-shaped contact section.

3. Lamp socket according to claim 1, characterised in that the contact section serving as a test pin support (25) is constructed as a tongue (22) which is cut out of a strip-shaped contact section and is bent over below the insulating protective collar (19).

4. Lamp socket according to claim 1, characterised in that the contact piece (14) has a free end (21) which extends beyond the region of the test pin support (25) and is secured in the socket body (11) against a stop (27).

## Revendications

1. Douille de lampe, pour des lampes à culot à ergots, en particulier pour des lampes fluorescentes, avec un corps de douille (11) constitué en un matériau isolant et des éléments de contact (14), y étant inclus, pour les tiges de contact de la lampe, ainsi que des bornes de raccordement (15) pour des conducteurs, avec des ouvertures (17) ménagées dans une paroi du corps de douille, afin d'introduire des pointes de contrôle se présentant sous forme de tige-, venant d'un adaptateur de contrôle, dans le corps de douille, à un endroit où elles viennent toucher les éléments de contact, et avec une collerette de protection isolante (19), formant un canal, entourant les ouvertures (17), afin de respecter les distances de cheminement ou de fuites superficielles et la valeur d'un entrefer, caractérisée en ce que sur chaque élément de contact (14) est constitué un tronçon de contact particulier faisant office de reposoir de tige de contrôle (25), qui est orienté devant l'extrémité intérieure (23) de la collerette de protection isolante (19), sensiblement verticalement par rapport à elle, et en ce que la collerette de protection isolante (19) est refoulée depuis la face extérieure (18) du corps de douille (11) vers l'intérieur dans le corps de douille (11).

2. Douille de lampe selon la revendication 1, caractérisée en ce que le tronçon de contact servant de reposoir de tige de contrôle (25) est constitué d'un coudage, à peu près en forme d'étagement, du tronçon de contact en forme de bande.

3. Douille de lampe selon la revendication 1, caractérisée en ce que le tronçon de contact, servant de reposoir de tige de contrôle (25), est réalisé à partir d'une languette (22), découpée à partir d'un tronçon de contact en forme de bande et repliée sous la collerette de protection isolante (19).

4. Douille de lampe selon la revendication 1, caractérisée en ce que l'élément de contact (14) présente une extrémité libre (21) s'étendant sur la zone du reposoir de tige de contrôle (25), qui est fixée dans le corps de douille (11), sur une butée (27).
